# EUROPEAN PATENT SPECIFICATION

(11) **EP 0 756 284 B1**
(45) Date of publication and mention of the grant of the patent: **17.04.2002**
(21) Application number: 96305546.2
(22) Date of filing: 29.07.1996
(51) Int. Cl.: G11C 8/00

(54) **High density two port memory cell**
Zweitorspeicherzelle mit hoher Dichte
Cellule de mémoire à densité élévée à deux portes

(30) Priority: 27.07.1995 US 1594
(43) Date of publication of application: 29.01.1997
(73) Proprietor: TEXAS INSTRUMENTS INCORPORATED, Dallas Texas 75265 (US)
(72) Inventor: Sheffield, Bryan D., Allen, TX 75002 (US); Drummond, John David, Wylie, TX 75098 (US)
(74) Representative: Legg, Cyrus James Grahame

(56) References cited:
- EP-A- 0 434 852
- US-A- 4 613 958
- IEEE 1992 CUSTOM INTEGRATED CIRCUITS CONFERENCE, May 1992, BOSTON, USA, pages 2721-2724, XP000340968 HASHIMOTO ET AL.: "NEW BASE CELL FOR HIGH DENSITY GATE ARRAY"

## Description

### TECHNICAL FIELD OF THE INVENTION

The present invention relates generally to memory cell design and, more particularly, to a high density two port memory cell.

### BACKGROUND OF THE INVENTION

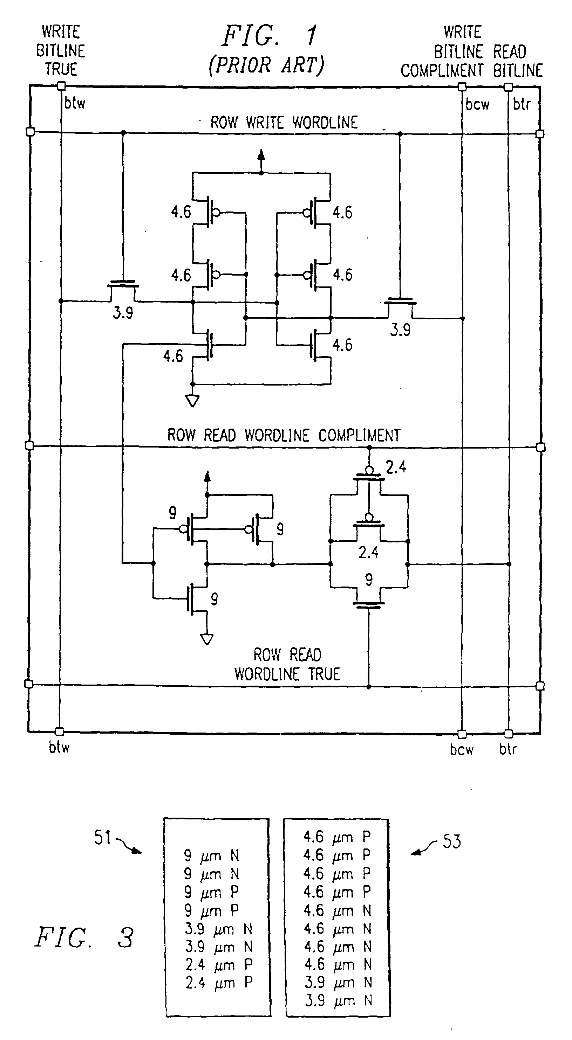

Figure 1 illustrates an example of a conventional two port memory cell. The example of Figure 1 has been heretofore available in the TGC3000 gate array product sold by Texas Instruments Incorporated. The memory cell of Figure 1 provides a single two port SRAM bit whose implementation requires two gate array base sites in the TGC3000 gate array product. The gate widths in microns of the various transistors in Figure 1 are shown therein. All of the exemplary transistors disclosed herein are assumed for purposes of explanation to have a 0.6 micro gate length.

The single two port memory bit of Figure 1 is constructed using transistors from two adjacent gate array base sites in the TGC3000 gate array product. Thus, two gate array base sites are required for every bit of two port memory.

It is therefore desirable to provide a two port memory cell design having a higher bit density in terms of bit-to-base site ratio than the memory cell design of Figure 1, on which the preambles of claims 1 and 2 are based.

According to the present invention there is provided a gate array comprising an array of base sites and including:
a memory cell array, comprising rows and columns of memory cells, formed from the gate array,
write ports each for writing data to a respective column of memory cells,
characterised in that each memory cell of the array is arranged to store two memory bits and is formed from two base sites of the gate array adjacent to each other in the direction of the rows of the memory cell array,
and in that the write port for that cell is shared between its two bits.

According to the present invention there is also provided a gate array comprising an array of base sites and including:
a memory cell array, comprising rows and columns of memory cells, formed from the gate array,
read ports each for reading data from a respective column of memory cells,
characterised in that each memory cell of the array is arranged to store two memory bits and is formed from two base sites of the gate array adjacent to each other in the direction of the rows of the memory cell array,
and in that the read port for that cell is shared between its two bits.

Thus the present invention may provide a two port memory cell design which has a higher bit-to-base site ratio than the prior art cell of Figure 1.

### BRIEF DESCRIPTION OF THE DRAWINGS

Figure 1 illustrates a single two port memory bit as conventionally implemented with transistors from two adjacent gate array base sites.

Figure 2 illustrates a pair of two port memory bits realized according to the present invention using transistors from two adjacent gate array base sites.

Figure 3 diagrammatically illustrates the two adjacent gate array base sites used in Figures 1 and 2.

### DETAILED DESCRIPTION

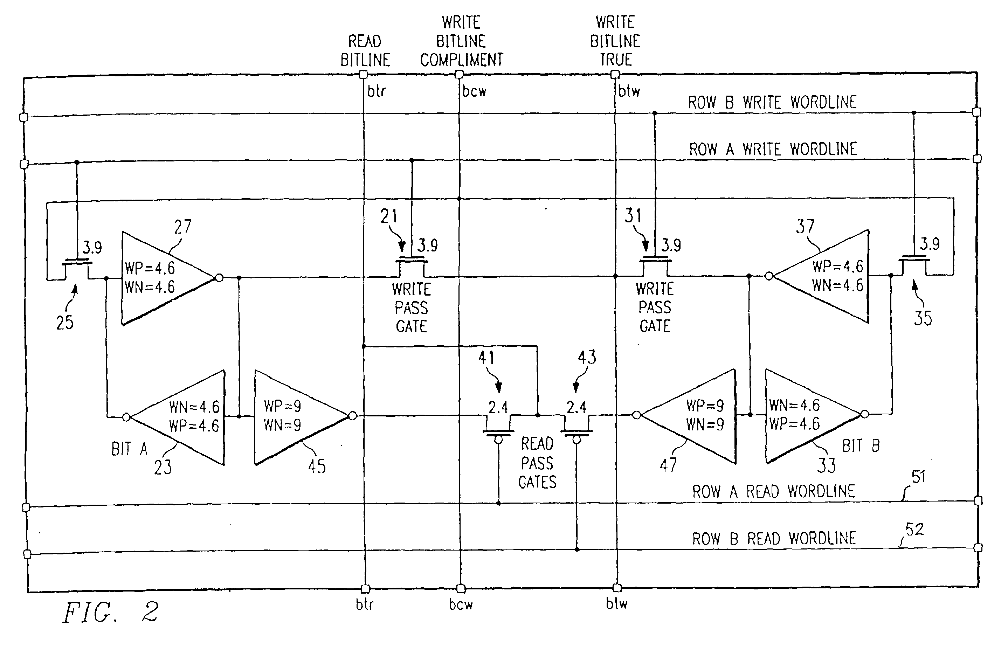

Exemplary Figure 2 illustrates a pair of two port SRAM bits realized according to the present invention using the transistors of two adjacent gate array base sites in the TGC3000 gate array product. The gate widths in microns of the transistors of Figure 2 are shown therein. Although the inverters are shown diagrammatically in Figure 2, the gate widths of their n-channel and p-channel transistors are respectively indicated by the symbols WN and WP. Comparison of Figures 1 and 2 reveals that all of the transistors of Figure 1 are used in the design of Figure 2, along with four additional n-channel transistors, two of the additional transistors having a 3.9 micron gate width and two of the additional transistors having a 4.6 micron gate width. The 18 transistors illustrated in Figure 2 represent every available transistor in two adjacent gate array base sites of the TGC3000 gate array product. One of the adjacent base sites includes two n-channel transistors having a 9 micron gate width, two p-channel transistors having a 9 micron gate width, two n-channel transistors having a 3.9 micron gate width and two p-channel transistors having a 2.4 micron gate width, and the drains of the 2.4 micron p-channel transistors are connected together. The other of the adjacent base sites includes four p-channel transistors having a gate width of 4.6 microns, four n-channel transistors having a gate width of 4.6 microns, and two n-channel transistors having a gate width of 3.9 microns. The above-described adjacent base sites are illustrated at 51 and 53 in Figure 3.

In Figure 2, the row A write wordline controls data writes to bit A. When the row A write wordline is active high, the data on write bitline true is switched through the write pass gate 21 to the input of inverter 23, and the data on write bitline complement is switched through pass gate 25 to the input of inverter 27. Data on write bitline true and write bitline complement are similarly applied to inverters 33 and 37 of bit B via pass gates 31 and 35 when the row B write wordline is active high. Thus, write bitline true and write bitline complement are shared by bit A and bit B.

The aforementioned drain-connected 2.4 micron p-channel transistors serve as read pass gates 41 and 43 in Figure 2. The connected drains of these pass gates are connected to a read bitline which is shared by both bit A and bit B. When the row A read wordline is active low, the output of inverter 45 drives the shared read bitline via pass gate 41. Similarly, when the row B read wordline is active low, the output of inverter 47 drives the shared read bitline via pass gate 43.

Because of the limited availability of transistors in the adjacent gate array base sites, the drain-connected 2.4 micron p-channel transistors are used as read pass gates 41 and 43 to drive the shared read bitline. The vertical direction routing is typically quite congested in gate array products such as the TGC3000, and the shared read bitline and shared write bitlines (true and complement) of Figure 2 make it possible to provide two bits of memory which both advantageously use the same three vertical control paths that were used in the single bit cell of Figure 1, namely btr (the read bitline), btw (the write bitline true) and bcw (the write bitline complement). Thus, the two bit memory cell of Figure 2 is vertically similar to the single bit memory cell of Figure 1 inasmuch as both designs are two gate array sites wide and have one vertical read bitline and one pair of vertical write bit lines. This permits the read and write column multiplexing circuitry associated with prior art Figure 1 to be re-used with the design of Figure 2, which reduces by at least 50 percent the layout work required to produce a memory array having the two bit memory cell structure of Figure 2.

Horizontal direction routing in products such as the TGC3000 is typically less congested than vertical direction routing, so the row A read wordline and the row B read wordline are advantageously provided horizontally to select whether bit A or bit B controls the shared read bitline. The row A and row B read wordlines in combination with the pass gates 41 and 43 effectively provide a row-enable controlled built-in 2:1 multiplexer. It will be noted that the Figure 2 cell includes only one more horizontal control line than the Figure 1 cell.

The respective cross-coupled inverter pairs 23, 27 and 33, 37 of bits A and B are balanced for uniform operation and easier characterization. The read is buffered by inverters 45 and 47 so as not to affect write operation.

The exemplary memory design of Figure 2 provides two bits of two port memory utilizing the same two adjacent gate array base sites as the single bit memory cell of Figure 1. Thus, the memory design of Figure 2 provides twice the bit density of the prior art design in Figure 1.

Although an exemplary embodiment of the present invention is described above, this description does not limit the scope of the invention, which can be practiced in a variety of embodiments.

## Claims

1. A gate array comprising an array of base sites and including:
a memory cell array, comprising rows and columns of memory cells, formed from the gate array,
write ports (bcw, btw) each for writing data to a respective column of memory cells,
**characterised in that** each memory cell of the array is arranged to store two memory bits (BIT A, BIT B) and is formed from two base sites of the gate array adjacent to each other in the direction of the rows of the memory cell array,
and **in that** the write port for that cell is shared between its two bits.

2. A gate array comprising an array of base sites and including:
a memory cell array, comprising rows and columns of memory cells, formed from the gate array,
read ports (btr) each for reading data from a respective column of memory cells,
**characterised in that** each memory cell of the array is arranged to store two memory bits (BIT A, BIT B) and is formed from two base sites of the gate array adjacent to each other in the direction of the rows of the memory cell array,
and **in that** the read port for that cell is shared between its two bits.

3. A gate array as claimed in claim 2 wherein each memory cell of the memory cell array comprises a multiplexer (41, 43) connected between the storage elements for its bits and said shared read port, and the gate array comprises, for each row said memory cells, a respective pair of enable lines (51, 52) so connected to the multiplexers of that row that they operate to connect selectively one or other of the bits stored by their respective memory cells to their respective read ports.

4. A gate array as claimed in claim 1 and as in claim 2 or claim 3.

## Patentansprüche

1. Gate-Array mit einer Matrix aus Basisplätzen und enthaltend:
eine Speicherzellenmatrix mit Zeilen und Spalten aus Speicherzellen, die aus dem Gate-Array gebildet sind,
Schreibtore (bcw, btw) jeweils zum Schreiben von Daten in eine entsprechende Speicherzellenspalte,
**dadurch gekennzeichnet, daß** jede Speicherzelle der Matrix so ausgestaltet ist, daß sie zwei Speicherbits (BIT A, BIT B) speichert und aus zwei Basisplätzen des Gate-Arrays gebildet ist, die in Richtung der Zeilen der Speicherzellenmatrix einander benachbart sind,
und daß das Schreibtor für diese Zelle von seinen zwei Bits gemeinsam benutzt wird.

2. Gate-Array mit einer Matrix aus Basisplätzen und enthaltend:
eine Speicherzellenmatrix mit Zeilen und Spalten aus Speicherzellen, die aus dem Gate-Array gebildet sind,
Lesetore (btr) jeweils zum Lesen von Daten aus einer jeweiligen Speicherzellenspalte,
**dadurch gekennzeichnet, daß** jede Speicherzelle der Matrix so ausgestaltet ist, daß sie zwei Speicherbits (BIT A, BIT B) speichert und aus zwei Basisplätzen des Gate-Arrays gebildet ist, die in Richtung der Zeilen der Speicherzellenmatrix einander benachbart sind,
und daß das Lesetor für diese Zelle von seinen zwei Bits gemeinsam benutzt wird.

3. Gate-Array nach Anspruch 2, bei dem jede Speicherzelle der Speicherzellenmatrix einen zwischen den Speicherelementen für ihre Bits und das gemeinsam benutzte Lesetor angeschlossenen Multiplexer (41, 43) enthält und das Gate-Array für jede Zeile der Speicherzellen jeweils zwei Freigabeleitungen (51, 52) aufweist, die an die Multiplexer der Zeile, die sie betreiben, so angeschlossen sind, daß das eine oder das andere der in ihren jeweiligen Speicherzellen gespeicherten Bits mit ihren jeweiligen Lesetoren verbunden wird.

4. Gate-Array nach Anspruch 1 und nach Anspruch 2 oder Anspruch 3.

## Revendications

1. Réseau de portes comprenant un réseau de sites de base et incluant :
un réseau de cellules de mémoire comprenant des rangs et des colonnes de cellules de mémoire, formé à partir du réseau de portes,
des ports d'écriture (bcw, btw) chacun pour écrire des données dans une colonne respective des cellules de mémoire,
**caractérisé en ce que** chaque cellule de mémoire du réseau est adaptée pour enregistrer deux bits de mémoire (BIT A, BIT B) et, est formée à partir de deux sites de base du réseau de portes, adjacents l'un à l'autre dans la direction des rangées du réseau de cellules de mémoire,
et **en ce que** le port d'écriture pour cette cellule est partagé entre ces deux bits.

2. Réseau de portes comprenant un réseau de sites de base et incluant :
un réseau de cellules de mémoire, comprenant des rangées et des colonnes de cellules de mémoire, formé à partir du réseau de portes,
des ports de lecture (btr) chacun pour lire des données à partir d'une colonne respective des cellules de mémoire,
**caractérisé en ce que** chaque cellule de mémoire du réseau est adaptée pour enregistrer deux bits de mémoire (BIT A, BIT B) et, est formée à partir de deux sites de base du réseau de portes, adjacents l'un à l'autre dans la direction des rangées du réseau de cellules de mémoire,
et **en ce que** le port de lecture pour cette cellule est partagé entre ces deux bits.

3. Réseau de portes selon la revendication 2, dans lequel chaque cellule de mémoire du réseau de cellules de mémoire comprend un multiplexeur (41, 43) connecté entre les éléments de stockage pour ces bits et ledit port d'écriture partagé, et le réseau de portes comprend, pour chaque rangée desdites cellules de mémoire, une paire respective de lignes d'activation (51, 52) connectées au multiplexeur de cette rangée de telle sorte qu'elles réalisent la connexion sélectivement de l'un ou de l'autre des bits stockés dans leurs cellules de mémoire respectives avec leurs ports de lecture respectifs.

4. Réseau de pontes selon la revendication 1, prise ensemble avec la revendication 2 ou 3.
